**Europäisches Patentamt**

**European Patent Office**

**Office européen des brevets**

(19)

(11) Numéro de publication: **0 308 338**
**A1**

(12)

# DEMANDE DE BREVET EUROPEEN

(21) Numéro de dépôt: **88402336.7**

(22) Date de dépôt: **16.09.88**

(51) Int. Cl.4: **H 01 L 39/24**
C 01 G 3/00, H 01 L 39/12,
C 04 B 35/00

(30) Priorité: **18.09.87 FR 8712936**

(43) Date de publication de la demande:
**22.03.89 Bulletin 89/12**

(84) Etats contractants désignés:
**AT BE CH DE ES FR GB GR IT LI LU NL SE**

(71) Demandeur: **RHONE-POULENC CHIMIE**
**25, quai Paul Doumer**
**F-92408 Courbevoie Cédex (FR)**

(72) Inventeur: **Lafon, Marie-Odile**
**15, rue Beautreilles**
**F-75004 Paris (FR)**

**Magnier, Claude**
**3, rue des Chaufourniers**
**F-75019 Paris (FR)**

(74) Mandataire: **Dubruc, Philippe et al**
**RHONE-POULENC INTERSERVICES Service Brevets**
**Chimie 25, quai Paul-Doumer**
**F-92408 Courbevoie Cédex (FR)**

(54) Procédé de préparation de matériaux supraconducteurs et matériaux ainsi obtenus.

(57) L'invention a trait à un procédé de préparation d'une poudre fine supraconductrice essentiellement à base d'au moins une terre rare, d'au moins un alcalino-terreux, de cuivre et d'oxygène, caractérisé en ce qu'il comprend les étapes suivantes :

a) on mélange en présence d'alcool d'une part une solution aqueuse de nitrates et/ou d'acétates d'au moins une terre rare, d'au moins un alcalino-terreux et de cuivre, et d'autre part une solution d'acide oxalique, le pH du mélange obtenu devant être compris entre 2 et 4 ;

b) on sépare le précipité obtenu ;

c) on opère ensuite le séchage du précipité ;

d) on calcine le produit séché ;

e) on opère éventuellement le broyage de la poudre calcinée.

Elle concerne également les produits obtenus par ledit procédé.

EP 0 308 338 A1

**Description**

## PROCEDE DE PREPARATION DE MATERIAUX SUPRACONDUCTEURS ET MATERIAUX AINSI OBTENUS

La présente invention a trait au domaine des matériaux supraconducteurs.

On sait que la supraconductivité se caractérise entre autre par la disparition de toute résistance électrique dans un corps porté à très basse température.

Jusqu'à un passé récent, l'état supraconducteur dans certains matériaux n'apparaissait qu'en-dessous d'une température seuil, dite "température critique", généralement proche du zéro absolu. Une telle contrainte a constitué à l'évidence un frein sérieux au développement sur une grande échelle de toutes les applications partiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalant de 70 à 90°K, voire jusqu'à 100°K.

Ces matériaux sont pour la plupart à base de terres rares, d'alcalino-terreux, de métaux de transition et d'oxgène. Plus spécifiquement, les systèmes étudiés les plus prometteurs semblent être ceux à base d'yttrium et/ou lanthane, de baryum et/ou de strontium et/ou de calcium, de cuivre et/ou de nickel et/ou de cobalt et/ou de manganèse, et d'oxygène.

La méthode de synthèse généralement décrite dans la littérature pour aboutir à ces matériaux repose sur une réaction en phase solide, à hautes températures (1 000°C), entre des oxydes et/ou des sels contenant un anion volatil (par exemple le carbonate) des éléments correspondants, ces derniers composés se présentant sous forme de poudres.

Toutefois, ce procédé présente l'inconvénient d'être d'un contrôle délicat et conduit à des poudres dont l'aptitude au frittage peut paraître insuffisante.

Or, au niveau de certaines applications pratiques, seule l'utilisation des produits frittés supraconducteurs présente un intérêt réel.

Il est donc essentiel de pouvoir disposer de matériaux frittés, denses et homogènes, ayant conservé les propriétés intrinsèques de supraconductivité des poudres de départ. Il en découle la nécessité de disposer tout d'abord de poudres supraconductrices homogènes présentant de bonnes aptitudes au frittage.

La présente invention a donc pour but de résoudre les problèmes ci-dessus et de proposer des moyens simples, efficaces et de mise en oeuvre aisée, pour obtenir de manière reproductible tant des poudres supraconductrices homogènes présentant une excellente aptitude au frittage que des matériaux frittés supraconducteurs de haute densité.

On a maintenant trouvé, et il s'agit là d'un des premiers objets de la présente invention, que l'on peut obtenir des poudres fines supraconductrices et frittables au moyen du procédé de préparation selon l'invention, ledit procédé étant caractérisé en ce qu'il comprend les étapes suivantes :

    a) on mélange en présence d'alcool d'une part une solution aqueuse de nitrates et/ou d'acétates d'au moins une terre rare, d'au moins un alcalino-terreux et de cuivre, et d'autre part une solution d'acide oxalique, le pH du mélange obtenu devant être compris entre 2 et 4 ;

    b) on sépare le précipité obtenu ;

    c) on opère ensuite le séchage du précipité ;

    d) on calcine le produit séché ;

    e) on opère éventuellement le broyage de la poudre calcinée.

Dans l'exposé qui suit, de la présente invention, on entend par terre rare d'une part tout élément du Tableau Périodique dont le numéro atomique est compris, inclusivement, entre 57 et 71, et d'autre part l'yttrium qui, par convention, est assimilé ici à une terre rare.

Les terres rares particulièrement préférées pour la mise en oeuvre de procédé selon l'invention sont l'yttrium et le lanthane.

D'autre part, les alcalino-terreux utilisables dans le présent procédé sont principalement le calcium, le baryum et le strontium.

Le choix des éléments au sein des familles ci-dessus se fera bien entendu en fonction de la nature et de la composition de la poudre supraconductrice que l'on désire obtenir.

De même, les proportions entre les divers éléments au sein de la solution de départ sont ajustées classiquement en fonction de la stoechiométrie désirée dans le produit final, celle-ci devant naturellement correspondre à l'obtention des propriétés supraconductrices.

Le procédé selon l'invention s'applique ainsi particulièrement bien à la fabrication des systèmes supraconducteurs du type Y-Ba-Cu-O. Ces systèmes ont été étudiés notamment dans un article paru dans le Journal of American Chemical Society, 1987, 109, 2528-2530.

Selon l'invention, la terre rare, l'alcalino-terreux et le cuivre sont présents dans la solution aqueuse initiale sous forme d'acétates et/ou de nitrates. Toutefois, préférentiellement, on opère avec une solution d'acétates.

Selon une autre caractéristique importante du procédé selon l'invention, le mélange entre la solution de sels (nitrates et/ou acétates) et la solution d'acide oxalique se fait en présence d'alcool, et ceci dans le but notamment de favoriser l'opération de précipitation ultérieure.

Cet alcool peut être introduit dans le système soit de manière indépendante et séparée, soit en ayant été préalablement mélangé avec au moins l'une des solutions de sels et d'acide oxalique. Selon un mode particulier de mise en oeuvre du procédé selon l'invention, on alcoolise d'abord la solution de sels puis on mélange la solution ainsi préparée à la solution d'acide oxalique.

La quantité d'alcool introduite n'est pas critique ; dans la pratique, on rajoute environ un volume d'alcool par volume de solution aqueuse de sels.

Tout alcool, pour autant qu'il soit substantiellement soluble dans l'eau, peut parfaitement convenir pour la mise en oeuvre du présent procédé. A titre d'exemple, les alcools aliphatiques à chaîne courte, comme le méthanol, l'éthanol et le propanol, conviennent bien.

La quantité d'acide oxalique introduite doit être suffisante pour permettre l'obtention, dans le mélange, d'un pH final compris entre 2 et 4. Ainsi, dans le cas d'un système Y-Ba-Cu-O, ce pH se situera préférentiellement aux environs de 3,5.

Bien entendu, on pourrait éventuellement ajuster le pH final du mélange au moyen d'un ajout d'acide complémentaire, tel que d'acide nitrique ou acétique, ou de base complémentaire, telle que d'ammoniaque.

A l'issue de ce mélange, il apparaît alors un précipité constitué essentiellement d'un mélange d'oxalates de terre rare, d'alcalino-terreux et de cuivre.

On sépare alors le précipité obtenu, par tout moyen connu en soi, notamment par filtration.

Il peut être préférable, avant de procéder au séchage, d'opérer un lavage du précipité, notamment par de l'eau, de l'alcool ou un mélange eau-alcool. De préférence, le lavage se fait au moyen d'alcool, tel que d'éthanol.

Le produit doit alors être séché.

Ce séchage pourra se faire tout moyen connu, notamment par séchage dans une étuve, ou par atomisation, c'est-à-dire par pulvérisation de la suspension dans une atmosphère chaude. De préférence, le séchage est réalisé dans une étuve classique, et à une température de l'ordre de 100°C.

Le produit séché est ensuite calciné.

La calcination est opérée à une température comprise entre 850°C et 1 000°C, de préférence comprise entre 900°C et 950°C. La durée de la calcination peut varier entre 30 mn et 24 heures par exemple, et de préférence entre 5 et 15 heures.

Cette calcination est conduite sous atmosphère d'air ou tout autre mélange air/oxygène, mais de préférence sous air.

D'autre part, selon un mode particulier de réalisation de l'invention, les produits calcinés sont refroidis très rapidement jusqu'à température ambiante, opération équivalente à une trempe, par exemple au moyen d'un balayage d'air froid. Le temps de refroidissement est généralement de l'ordre de quelques secondes.

A la suite de cette calcination, on obtient une poudre supraconductrice présentant une granulométrie macroscopique de 1 à 10 μ, les grains de 1 à 10 μ étant constitués de cristallites élémentaires de taille comprise entre 100 Å et 500 Å environ.

Les poudres obtenues doivent généralement être broyées, de préférence à sec, de manière à pouvoir conduire un bon frittage. La répartition moyenne des poudres se situe entre environ 0,5 et 2 μm, de préférence entre 1 et 2 μm.

Ces poudres supraconductrices présentent la propriété remarquable de pouvoir donner, après frittage, des matériaux frittés supraconducteurs, parfaitement homogènes, et dont la densité est supérieure à 95 % de la densité théorique du matériau considéré.

La température de frittage des poudres est comprise entre 900°C et 1 000°C, et le temps de frittage généralement compris entre 2 et 10 heures. Ce frittage est de préférence conduit sous une atmosphère d'oxygène.

Plus spécifiquement, les caractéristiques des poudres supraconductrices selon l'invention, au regard de leur aptitude au frittage, sont déterminées de la façon suivante :

la poudre est tout d'abord pastillée, avec ou sans liant, sous une pression uniaxiale de 1,5 T/cm², puis frittée pendant 2 heures à une température de 950°C, et refroidie pendant 7 heures jusqu'à température ambiante ; on mesure alors la densité du produit obtenu. Dans tous les cas, on observe une densité finale supérieure à 95 % de la densité théorique du matériau considéré.

D'autre part, on observe que le produit fritté obtenu présente de très bonnes propriétés supraconductrices.

D'autres avantages et aspects de l'invention apparaîtront à la lecture de l'exemple qui suit.

## Exemple

Cet exemple illustre l'invention dans le cadre de la préparation d'un matériau supraconducteur de formule $Y-Ba_2-Cu_3-O_x$ ($6,5 \leq x \leq 7$).

A - Préparation de la poudre Dans 2,25 l d'eau, on dissout 30 g d'acétate d'yttrium, 43,5 g d'acétate de baryum et 53,1 g d'acétate de cuivre.

On ajoute à cette solution 2,25 l d'éthanol.

On introduit en continu dans un réacteur, à l'aide de pompes, 34,88 ml/mn de cette solution avec 9,3 ml/mn d'une solution d'acide oxalique 0,5 M.

Il se forme un précipité qui est ensuite filtré, puis lavé à l'alcool (éthanol), puis séché dans une étuve à 100°C.

La poudre ainsi obtenue est calcinée à 900°C pendant 10-15 heures sous air.

Le produit est ensuite très rapidement ramené à température ambiante.

Puis on effectue un broyage à sec jusqu'à l'obtention d'une poudre dont la granulométrie moyenne est inférieure à 2 μm.

Les caractéristiques de la poudre obtenue sont alors les suivants :
- surface spécifique (BET)   : 2 m²/g
- volume poreux total   : 0,32 cm³/g
dont un volume réel   : 0,25 cm³/g
et un volume intergranulaire   : 0,07 cm³/g
- domaine de porosité   : 0,02-5 μm
- diamètre moyen des pores   : 0,9 μm
- granulométrie moyenne   : 1,7 μm
- taille moyenne des cristallites   : environ 300 Å.

B - Frittage de la poudre La poudre est pastillée par pressage à sec uniaxial sous une pression de 1,5 T/cm², puis frittée à 950°C pendant 2 heures sous oxygène et refroidie en 7 heures jusqu'à température ambiante.

On obtient alors un matériau présentant une densité égale à 97 % de sa densité théorique.

Ce matériau est supraconducteur, sa température "onset" de début de transition est de 92°K et il répond à la formule moyenne Y-Ba$_2$-Cu$_3$-O$_{6.9}$.

**Revendications**

1 - Procédé de préparation d'une poudre fine supraconductrice essentiellement à base d'au moins une terre rare, d'au moins un alcalino-terreux, de cuivre et d'oxygène, caractérisé en ce qu'il comprend les étapes suivantes :

    a) on mélange en présence d'alcool d'une part une solution aqueuse de nitrates et/ou d'acétates d'au moins une terre rare, d'au moins un alcalino-terreux et de cuivre, et d'autre part une solution d'acide oxalique, le pH du mélange obtenu devant être comprise entre 2 et 4 ;

    b) on sépare le précipité obtenu ;

    c) on opère ensuite le séchage du précipité ;

    d) on calcine le produit séché ;

    e) on opère éventuellement le broyage de la poudre calcinée.

2 - Procédé selon la revendication 1 caractérisé en ce que l'on utilise une solution d'acétates.

3 - Procédé selon l'une quelconque des revendications précédentes caractérisé en ce que l'on utilise un alcool aliphatique substantiellement soluble dans l'eau.

4 - Procédé selon la revendication 3 caractérisé en ce que ledit alcool est choisi parmi le méthanol, l'ethanol et le propanol.

5 - Procédé selon l'une quelconque des revendications 3 et 4 caractérisé en ce que l'on utilise une quantité d'alcool correspondant à un volume d'alcool par volume de solution aqueuse.

6 - Procédé selon l'une quelconque des revendications précédentes caractérisé en ce que l'on sépare le précipité obtenu par filtration.

7 - Procédé selon l'une quelconque des revendications précédentes caractérisé en ce que, avant séchage, le précipité obtenu est lavé au moyen d'eau, d'alcool, ou d'un mélange eau-alcool.

8 - Procédé selon la revendication 7 caractérisé en ce que l'on utilise de l'alcool.

9 - Procédé selon l'une quelconque des revendications précédentes caractérisé en ce que ladite calcination s'effectue entre 850°C et 1 000°C, de préférence entre 900°C et 950°C.

10 - Procédé selon l'une quelconque des revendications précédentes caractérisé en ce que la calcination s'effectue sous air.

11. Procédé selon la revendication 10 caractérisé en ce que ledit broyage amène les produits calcinés à une granulométrie moyenne inférieure à 2 microns, de préférence comprise entre 1 et 2 μm.

12. Procédé selon l'une quelconque des revendications précédentes caractérisé en ce que l'on utilise une solution de nitrates.

13. Procédé selon l'une quelconque des revendications précédentes caractérisé en ce que les terres rares sont choisies parmi l'yttrium et le lanthane.

14. Procédé selon l'une quelconque des revendications précédentes caractérisé en ce que les alcalino-terreux sont choisis parmi le calcium, le baryum et le strontium.

15. Procédé selon l'une quelconque des revendications précédentes caractérisé en ce que les métaux de transition sont choisis parmi le cuivre, le nickel, le manganèse, le cobalt et le fer.

16. Procédé selon l'une quelconque des revendications précédentes caractérisé en ce que l'on utilise une solution aqueuse de nitrates d'yttrium, de baryum et de cuivre

17. Procédé céramique supraconductrice essentiellement à base d'une terre rare, d'au moins un alcalino-terreux, d'au moins un métal De transition et d'oxygène, susceptible d'être obtenue par la mise en oeuvre d'un procédé tel que défini à l'une quelconque des revendications 1 à 16.

18 Matériau céramique fritté supraconducteur essentiellement à base d'une terre rare, d'au moins un alcalino-terreux, d'au moins un métal de transition et d'oxygène, susceptible d'être obtenu par frittage d'une poudre selon la revendication 17.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | JAPANESE JOURNAL OF APPLIED PHYSICS, PROCEEDNGS OF THE SIXTH INTERNATIONAL MEETING ON FERROELECTRICITY, Kobe 1985, vol. 24, 1985, supplément 24-2, pages 439-441, Tokyo, JP; B.M. SONG et al.: "Preparation of PLZT ceramics by oxalate method in ethanol solution" * Paragraphe 2, "Experimental procedure"; figure 1 * | 1-4,6-10,12-18 | H 01 L 39/24<br>C 01 G 3/00<br>H 01 L 39/12<br>C 04 B 35/00 |
| A | IDEM. | 5 | |
| Y | JAPANESE JOURNAL OF APPLIED PHYSICS, vol. 26, no. 5, partie 2, mai 1987, pages L734-L735, Tokyo, JP; K. KANEKO et al.: "On the coprecipitation method for the preparation of high TcM-X-Cu-O (M=Ba,Sr,X=La, Y) system" * En entier * | 1-4,6-10,12-18 | |
| Y | JAPANESE JOURNAL OF APPLIED PHYSICS, vol. 26, no. 1, partie 2, janvier 1987, pages L1-L2, Tokyo, JP; S.I. UCHIDA et al.: "High Tc superconductivity of La-Ba-Cu oxides" * Page L1, colonne 2, lignes 1-12 * | 2,18 | **DOMAINES TECHNIQUES RECHERCHES (Int. Cl.4)**<br><br>H 01 L<br>C 01 G |
| A | IDEM. | 1,9,10, 13-15, 17 | |
| | ---                          -/- | | |

**Le présent rapport a été établi pour toutes les revendications**

| Lieu de la recherche | Date d'achèvement de la recherche | Examinateur |
|---|---|---|
| LA HAYE | 15-12-1988 | MORVAN D.L.D. |

EPO FORM 1503 03.82 (P0402)

Office européen
des brevets

Numero de la demande

EP 88 40 2336

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | JAPANESE JOURNAL OF APPLIED PHYSICS, vol. 26, no. 5, partie 2, mai 1987, pages L836-L837, Tokyo, JP; Y. SAITO et al.: "Superconductivity of Sr-La-Cu-O oxides prepared by copreciptation method" <br> * Page L836, colonne 1, lignes 13-19 * <br> --- | 1,6,9, 10,12-15,17, 18 | |
| A | MATERIALS LETTERS, vol. 5, no. 4, mars 1987, pages 165-169, Amsterdam, NL; I.K. GOPALAKRISHNAN et al.: "On the synthesis and superconducting properties of La1.8M0.2CuO4 systems" <br> * Page 166, paragraphe 3, lignes 1-14 * <br> ----- | 1,10,11 -15,17, 18 | |
| | | | DOMAINES TECHNIQUES RECHERCHES (Int. Cl.4) |

Le présent rapport a été établi pour toutes les revendications

| Lieu de la recherche | Date d'achèvement de la recherche | Examinateur |
|---|---|---|
| LA HAYE | 15-12-1988 | MORVAN D.L.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)